# EUROPEAN PATENT APPLICATION

(11) **EP 4 266 348 A1**
(43) Date of publication of application: **25.10.2023**
(21) Application number: 21913861.7
(22) Date of filing: 13.12.2021
(51) Int. Cl.: H01J 37/32

(54) **ION SOURCE DEVICE WITH ADJUSTABLE PLASMA DENSITY**

(30) Priority: 04.01.2021 CN 202110002081
(71) Applicant: Jiangsu Leuven Instruments Co. Ltd, Xuzhou, Jiangsu 221300 (CN)
(72) Inventor: ZHANG, Yaoyao, Xuzhou, Jiangsu 221300 (CN); LIU, Xiaobo, Xuzhou, Jiangsu 221300 (CN); HU, Dongdong, Xuzhou, Jiangsu 221300 (CN); ZHANG, Huaidong, Xuzhou, Jiangsu 221300 (CN); LIU, Haiyang, Xuzhou, Jiangsu 221300 (CN); LI, Na, Xuzhou, Jiangsu 221300 (CN); GUO, Song, Xuzhou, Jiangsu 221300 (CN); LI, Xiaolei, Xuzhou, Jiangsu 221300 (CN); XU, Kaidong, Xuzhou, Jiangsu 221300 (CN)
(74) Representative: Behr, Wolfgang
(86) International application number: PCT/CN2021/137434
(87) International publication number: WO 2022/143120

(57) **Abstract**

The present application discloses an ion source device with an adjustable plasma density, comprising an ion source cavity, a discharge cavity, a spiral coil, a planar coil and a radio frequency power supply, wherein the ion source cavity and the discharge cavity are coaxially provided from outside to inside, a head of the discharge cavity is provided with an air inlet panel; the spiral coil is coaxially sleeved on the periphery of a barrel body of the discharge cavity, and a radial gap R is provided therebetween; the planar coil is coaxially mounted upstream of the outer side of the air inlet panel, and an axial gap L is provided therebetween; one end of the spiral coil and one end of the planar coil are both sequentially electrically connected to a power divider, a radio frequency matcher and the radio frequency power supply, and the other ends of the two are both grounded; and the power divider can divide the radio frequency power entering the spiral coil and the planar coil, so that the adjustment of the plasma density distribution in the discharge cavity is implemented by adjusting the division rate r.

## Description

### CROSS-REFERENCE TO RELATED APPLICATION

This application claims priority to Chinese patent application NO. 2021100020819 filed on January 4, 2021 and entitled "ION SOURCE DEVICE WITH ADJUSTABLE PLASMA DENSITY", the disclosure of which is hereby incorporated by reference in its entirety.

### TECHNICAL FIELD

The present invention relates to the technical field of ion beams etching, and in particular to an ion source device with an adjustable plasma density.

### BACKGROUND

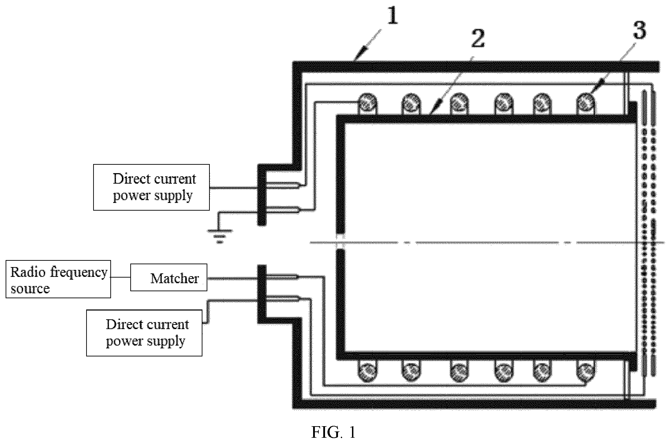

An ion source is a key component of ion beams etching, and a quality of the ion source directly affects etching performances. A radio frequency inductively coupled ion source is widely used in fields such as the ion beams etching, material surface modifications, and thin films processing due to its advantages of high density, pollution-free, easy maintenance, and long service life. Compared with electron cyclotron oscillation sources and spiral wave sources, the design and process of inductively coupled ion source are relatively simple and an uniform plasma can be generated without the constraint of the external magnetic field. The radio frequency inductively coupled ion source is mainly a spiral structure based on a shape of an antenna. An entire structure of the ion source is mainly composed of an radio frequency antenna, a plasma discharge cavity, and an extraction system. The operating principle is that: when a certain radio frequency current flows into a radio frequency coil located on a dielectric window, an induced radio frequency electric field is induced in the discharge cavity. The induced electric field accelerates movements of electrons, such that the electrons continuously collide and ionize with neutral gas molecules, thereby coupling radio frequency energy in the induction coil into the ionized gas to maintain the plasma for discharge. Most of ions that are generated by radio frequency discharge are extracted through a gird system to form ion beams, as illustrated in FIG. 1.

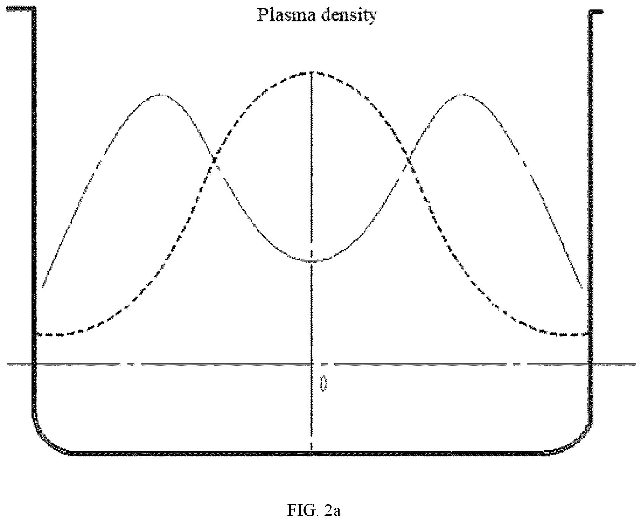

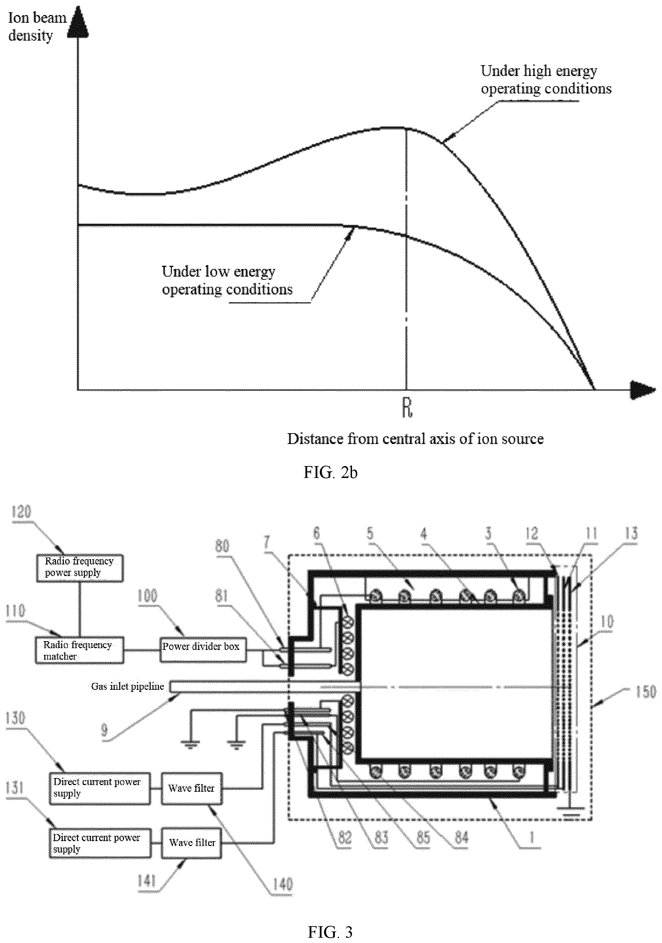

During a use process of the existing ion sources, spiral coils are mostly adopted. When the spiral coil is energized, the plasma density is highest within a skin layer thereof, and gradually decreases in areas outside the skin layer. Under a low pressure condition, the plasma density in the discharge cavity mostly exhibits as a parabolic distribution, as illustrated by a dashed line in FIG. 2a. With an increase of the currents, skin effects at the edges increase, and the distribution of the plasma density in the discharge cavity generally exhibits as a saddle-shape. The distributions of the plasma density at the center and at the edges are uneven, as illustrated by a solid line in FIG. 2b. This problem is solved by providing different size of apertures on the screen grid in the existing method. Generally, the apertures located in the medium of the screen gird are small and the sizes of the apertures at the edges increase, which can merely improve uniformity at the edges under low energy conditions, cannot adjust multiple operating conditions, and affects etching uniformity in case of high energy conditions.

### SUMMARY

The exemplary embodiments of the present invention provide an ion source device with an adjustable plasma density, which adopts a spiral coil and a planar coil simultaneously and divides power of the two coils by adjustments according to different operating conditions, thus effectively solving the above-mentioned problems and improving etching uniformity.

The exemplary embodiments of the present invention provide an ion source device with an adjustable plasma density, which includes an ion source cavity, a discharge cavity, a spiral coil, a planar coil and a radio frequency power supply. The ion source cavity and the discharge cavity are coaxially provided from outside to inside. A head of the discharge cavity is provided with a gas inlet panel. The spiral coil is coaxially sleeved on a periphery of a barrel body of the discharge cavity, and a radial gap R is provided between the spiral coil and an outer wall surface of the barrel body of the discharge cavity. The planar coil is coaxially mounted upstream an outer side of the gas inlet panel, and an axial gap L is provided between the planar coil and an outer surface of the gas inlet panel. One terminal of the spiral coil and one terminal of the planar coil are both sequentially electrically connected to a power divider, a radio frequency matcher and the radio frequency power supply, and another terminal of the spiral coil and another terminal of the planar coil are both grounded. The power divider is capable of dividing radio frequency powers entering the spiral coil and the planar coil, so that adjustments for plasma density distributions in the discharge cavity are implemented by an adjustment for a division rate r, the division rate r=P1:P2, where P1 is the radio frequency power entering the spiral coil and P2 is the radio frequency power entering the planar coil.

In one embodiment, the division rate r ranges from 1:20 to 20:1.

In one embodiment, the planar coil is a single disc-shaped coil.

In one embodiment, the planar coil is an alternating combination of two disc-shaped coils.

In one embodiment, the radial gap R provided between the spiral coil and the outer wall surface of the barrel body of the discharge cavity ranges from 2 mm to 30 mm, and the axial gap L provided between the planar coil and the outer surface of the gas inlet panel ranges from 2 mm and 30 mm.

In one embodiment, the spiral coil is arranged on the inner wall surface of a barrel body of the ion source cavity through a spiral coil supporter, and the planar coil is arranged on an inner wall surface of a head panel of an ion source through a planar coil supporter.

In one embodiment, Grid components are arranged on a tail terminal of the ion source cavity and a tail terminal of the discharge cavity, the Grid components include a screen grid and an acceleration grid, the screen grid is configured to focus plasmas, and the acceleration grid is configured to accelerate ion beams.

In one embodiment, the Grid components further include a deceleration gird arranged downstream the acceleration grid, and the deceleration gird is configured to reduce divergences of the ion beams.

The beneficial effects of the present invention lie in the following. A spiral coil and a planar coil are adopted simultaneously and power of the two coils is divided by adjustments according to different operating conditions, thus effectively improving the etching uniformity. The adjustment and usage methods specifically lie in the following.
1. In the present invention, under a low energy condition, the spiral coil operates alone to ensure an uniform distribution of plasmas in the discharge cavity, therefore, the utilization of the spiral coil alone can ensure an excellent uniformity without power allocation on the planar coil.
2. In the present invention, under a medium energy condition, uniform plasmas can be generated in the discharge cavity by the planar coil, therefore, the planar coil can operate alone to ensure etching uniformity.
3. In the present invention, under a high energy condition, the spiral coil alone is utilized, the plasma density distributions in the discharge cavity are low in the medium and high on two sides, at this time, power is loaded on the planar coil to correct the plasma density distributions in the discharge cavity, such that the plasma density distributions in the discharge cavity tend to be uniform, which is conducive to improving the etching uniformity.

### BRIEF DESCRIPTION OF THE DRAWINGS

FIG. 1 illustrates a schematic diagram of a spiral radio frequency inductively coupled ion source in the prior art.
FIG. 2a and 2b illustrate a schematic diagram of plasma density distributions in the discharge cavity.
FIG. 3 illustrates a structure schematic diagram of an ion source device with an adjustable plasma density in one embodiment of the present invention.
FIG. 4 illustrates a structure schematic diagram of a planar coil adopting a single disc-shaped coil in one embodiment of the present invention.
FIG. 5 illustrates a structure schematic diagram of a planar coil adopting a combination of two disc-shaped coils in one embodiment of the present invention.
FIG. 6 illustrates a schematic diagram of a workflow of an ion source in one embodiment of the present invention. FIG. 6(a) illustrates a workflow diagram of the spiral coil that operates alone. FIG. 6(b) illustrates a workflow diagram of a planar coil operating alone. FIG. 6(c) illustrates a workflow diagram of the spiral coil and the planar coil operating simultaneously.
FIG. 7 illustrates a schematic diagram of the plasma density distributions when the spiral coil and the planar coil operate alone in one embodiment.
FIG. 8 illustrates a corrected schematic diagram of plasma density distributions when the spiral coil and the planar coil operate simultaneously in one embodiment.

Descriptions of reference numerals are as follows.

1. Ion source cavity; 2. Discharge cavity; 3.Spiral coil; 5. Spiral coil supporter; 6. Planar coil; 61. Planar coil supporter; 7. Planar coil supporter; 80 to 85. Radio frequency column; 9. Gas inlet pipeline; 10. Grid component; 11. Screen gird; 12. Acceleration grid; 13. Deceleration grid; 100. Power divider; 110. Video matcher; 120. Video power supply; 130 to 131. Direct current power supply; 140 to 141. Wave filter; 150. Main ion source cavity.

### DETAILED DESCRIPTION OF THE EMBODIMENTS

The present invention will be further clarified in conjunction with the accompanying drawings and the specific relatively preferred embodiments.

In the descriptions of the present invention, it should be understood that the orientations or position relationships indicated by the terminologies such as "left side", "right side", "upper part" and "below part" are based on the orientations or position relationships illustrated in the accompanying drawings, which is merely for the conveniences of describing the present invention and simplifying the descriptions, rather than indicating or implying that the device or the components referred to must have specific orientations, be constructed and operated in specific orientations. The "first" and "second" does not represent the importance of the components, therefore it cannot be understood as a limitation to the present invention. The specific dimensions adopted in this embodiment are merely to exemplify the technical solutions and do not limit the scope of the present invention.

As illustrated in FIG. 3, the exemplary embodiments of the present invention provide an ion source device with an adjustable plasma density, which includes a main ion source cavity 150 and a radio frequency power supply 120.

The main ion source cavity 150 includes an ion source cavity 1, a discharge cavity 2, a spiral coil 3, a planar coil 6 and Grid components 10.

The ion source cavity and the discharge cavity are coaxially provided from outside to inside.

A head of the discharge cavity is provided with a gas inlet panel, and a gas inlet pipeline 9 is arranged on a medium part of the gas inlet panel.

The spiral coil is coaxially sleeved on a periphery of a barrel body of the discharge cavity, and the spiral coil is preferably arranged on the inner wall surface of a barrel body of the ion source cavity through a spiral coil supporter 5.

A radial gap R is provided between the spiral coil and an outer wall surface of the barrel body of the discharge cavity, and R is preferably ranges from 2 mm to 30 mm.

The planar coil is coaxially mounted upstream an outer side of the gas inlet panel, and the planar coil is preferably arranged on an inner wall surface of a head panel of an ion source through a planar coil supporter 7.

An axial gap L is provided between the planar coil and an outer surface of the gas inlet panel, and L preferably ranges from 2 mm to 30 mm.

The settings of the above-mentioned the radial gap R and the axial gap L can generate relatively uniform plasmas in the discharge cavity.

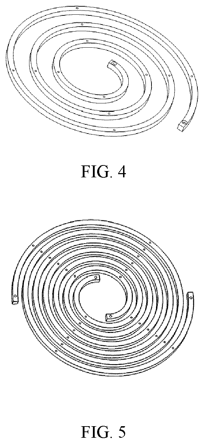

The above-mentioned planar coil 6 is preferably a disc-shaped coil. The planar coil 6 can be formed by a single disc-shaped coil as illustrated in FIG. 4. In order to enable the plasma density distributions to be more uniform, the planar coil can also be composed of two disc-shaped coils as illustrated in FIG. 5. The cross-sectional shape of the disc-shaped coil is not limited and can be circular or square.

Moreover, the materials of the above-mentioned spiral coil supporter and the planar coil supporter are preferably insulating materials such as ceramic, while the materials of the discharge cavity is preferably ceramic or quartz.

The above-mentioned Grid components are installed at the tail terminals of the ion source cavity and the discharge cavity. The Grid components 10 can choose two grids or three grids. The two grids includes the screen grid 12 and the acceleration grid 11. The screen grid 12 is capable of focusing the plasmas to form the ion beams, and the acceleration grid 11 is capable of accelerating the ion beams. The three grids are to add a deceleration grid 13 on the basic of the two grids, and the deceleration grid 13 is grounded, which is capable of effectively reducing divergences of the ion beams. After being filtered by the wave filters 140 and 141, direct current power supplies 130 and 131 are respectively connected to the screen grid 12 and acceleration grid 11 of the grid components 10 through radio frequency columns 84 and 85. The grid 12 is negatively charged and the acceleration grid 11 is positively charged.

One terminal of the spiral coil and one terminal of the planar coil are sequentially connected to the power divider 100, the radio frequency matcher 110, and the radio frequency power supply 120, and another terminal of the spiral coil and another terminal of the planar coil are grounded respectively.

In one embodiment, the specific electrical connection mode is as follows. In order to maximize the power transmission of the radio frequency power supply 100, an radio frequency matcher 110 needs to be connected after the radio frequency power supply 100 to match the load impedance with the impedance of the radio frequency power supply 100, thereby reducing the reflected power and ensuring the maximum transmission power. The radio frequency matcher 110 is connected to the power divider 100, and the power divider 100 is in-built with a power division circuit composed of a plurality of capacitors and inductors. One circuit of the power division circuit is connected to one terminal of the spiral coil 3 through the radio frequency column 83, and another terminal of the spiral coil 3 is grounded through the radio frequency column 80. At the same time, another circuit of the power division circuit is connected to one terminal of the planar coil 6 through the radio frequency column 81, and another terminal of the planar coil 6 is grounded through the radio frequency column 82.

In other words, the power divider is capable of dividing the radio frequency power entering the spiral coil and the planar coil, and the adjustments for the plasma density distributions in the discharge cavity are implemented by the adjustments for the division rate r. The division rate r=P1: P2, where P1 is the radio frequency power entering the spiral coil and P2 is the radio frequency power entering the planar coil. In the present invention, the division rate r preferably ranges from 1:20 to 20:1. Assuming that under a certain operating condition, when the spiral coil is operated independently, the plasma density in the discharge cavity shows a trend of high at the edges and low in the medium. Power disivion can be carried out on the planar coil and the spiral coil, and the planar coil compensates for the plasma density in the medium, such that the plasma density in the entire discharge cavity is uniformly distributed.

When the etching is required, the direct current power supplies 130 and 131 and the radio frequency power supply 120 are started, the plasma gas such as Ar and O₂ enters the discharge cavity 2 through the gas inlet pipeline 9. Under the action of the spiral coil 3 and the planar coil 6, the gas in the discharge cavity is ionized to generate plasmas. The plasmas in discharge cavity 4 are extracted through the Grid components 10 and bombarded in a form of ion beams to etch the wafer.

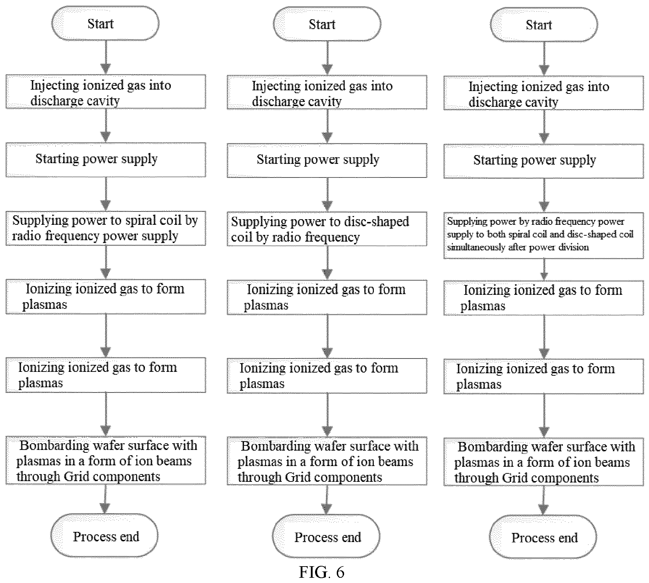

In the present invention, the spiral coil and the planar coil can operate independently or in collaboration, and the workflow is as illustrated in FIG. 6.

In one embodiment, the spiral coil operates independently.

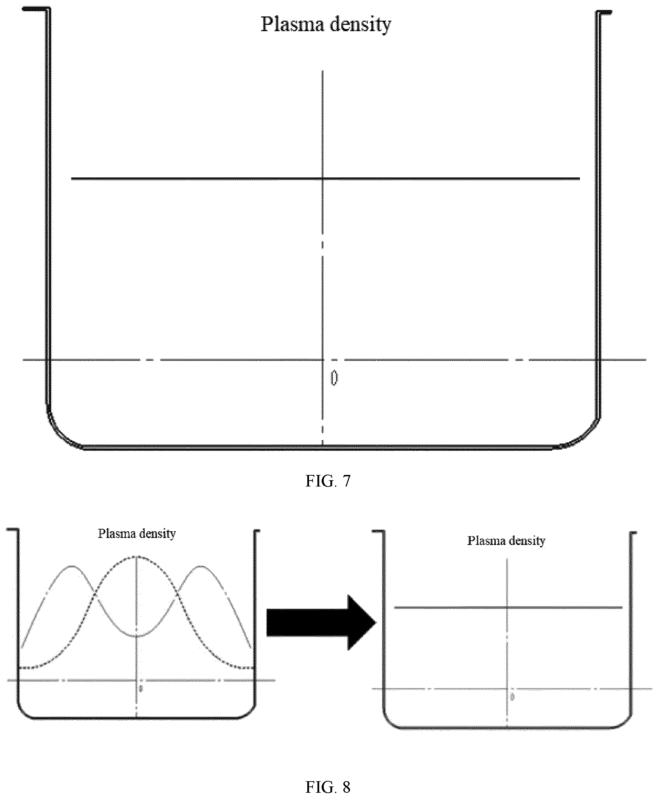

As illustrated in FIG. 6(a), the resonance can be generated in the megahertz range by adopting the spiral coil 3, and the plasmas can be effectively generated under the low pressure, and the energy can be efficiently transferred to the plasmas. Assuming that under a low energy condition (or a certain operating condition), the spiral coil operates independently, which can ensure uniform distributions of plasma in the discharge cavity, as specifically illustrated in FIG. 7. Therefore, without power disivion on the planar coil, the excellent uniformity can be ensured by independently utilizing the spiral coil.

In one embodiment, the planar coil operates independently.

As illustrated in FIG. 6(b), assuming that under a medium energy condition (or a certain operating condition), the uniform plasmas can be generated in the discharge cavity 4 by the planar coil 6. Therefore, the etching uniformity can be ensured by independently operating the planar coil.

In one embodiment, the spiral coil and the planar coil operate simultaneously.

Two coils of the spiral coil and the planar coil are adopted and different power loads are applied to the two coils. For example, under a high energy condition, the spiral coil is utilized alone, the plasma density distributions in the discharge cavity are low in the medium and high on the edges. At this time, the power is loaded on the planar coil to correct the plasma density in the discharge cavity, such that the plasma density in the discharge cavity tends to be uniform, which is conducive to improving the etching uniformity. That is, the graph of the plasma density on the left side of FIG. 8 is corrected to the schematic diagram of the plasma density on the right side of FIG. 8.

Preferred embodiments of the present invention are specifically described above. However, the present invention is not limited to the specifically details in the above-mentioned embodiments. Multiple equivalent variations can be made to the technical solutions of the present invention within the scope of the technical concept of the present invention, and these equivalent variations all fall within the protection scope of the present invention.

## Claims

1. An ion source device with an adjustable plasma density, wherein the device comprises an ion source cavity, a discharge cavity, a spiral coil, a planar coil and a radio frequency power supply;
the ion source cavity and the discharge cavity are coaxially provided from outside to inside, and a head of the discharge cavity is provided with a gas inlet panel;
the spiral coil is coaxially sleeved on a periphery of a barrel body of the discharge cavity, and a radial gap R is provided between the spiral coil and an outer wall surface of the barrel body of the discharge cavity;
the planar coil is coaxially mounted upstream an outer side of the gas inlet panel, and an axial gap L is provided between the planar coil and an outer surface of the gas inlet panel;
one terminal of the spiral coil and one terminal of the planar coil are both sequentially electrically connected to a power divider, a radio frequency matcher and the radio frequency power supply, and another terminal of the spiral coil and another terminal of the planar coil are both grounded; and
the power divider is capable of dividing radio frequency powers entering the spiral coil and the planar coil, so that adjustments for plasma density distributions in the discharge cavity are implemented by an adjustment for a division rate r; wherein the division rate r=P1:P2, where P1 is the radio frequency power entering the spiral coil and P2 is the radio frequency power entering the planar coil.

2. The ion source device with the adjustable plasma density according to claim 1, wherein the division rate r ranges from 1:20 to 20: 1.

3. The ion source device with the adjustable plasma density according to claim 1, wherein the planar coil is a single disc-shaped coil.

4. The ion source device with the adjustable plasma density according to claim 1, wherein the planar coil is an alternating combination of two disc-shaped coils.

5. The ion source device with the adjustable plasma density according to claim 1, wherein the radial gap R provided between the spiral coil and the outer wall surface of the barrel body of the discharge cavity ranges from 2 mm to 30 mm, and the axial gap L provided between the planar coil and the outer surface of the gas inlet panel ranges from 2 mm and 30 mm.

6. The ion source device with the adjustable plasma density according to claim 1, wherein the spiral coil is arranged on the inner wall surface of a barrel body of the ion source cavity through a spiral coil supporter, and the planar coil is arranged on an inner wall surface of a head panel of an ion source through a planar coil supporter.

7. The ion source device with the adjustable plasma density according to claim 1, wherein Grid components are arranged on a tail terminal of the ion source cavity and a tail terminal of the discharge cavity, the Grid components include a screen grid and an acceleration grid, wherein the screen grid is configured to focus plasmas, and the acceleration grid is configured to accelerate ion beams.

8. The ion source device with the adjustable plasma density according to claim 7, wherein the Grid components further include a deceleration gird arranged downstream the acceleration grid, and the deceleration gird is configured to reduce divergences of the ion beams.
